(19)

Europäisches Patentamt

European Patent Office

Office européen des brevets

(11) **EP 4 679 643 A1**

(12) **EUROPEAN PATENT APPLICATION**

(43) Date of publication:
**14.01.2026 Bulletin 2026/03**

(21) Application number: **25186212.4**

(22) Date of filing: **30.06.2025**

(51) International Patent Classification (IPC):
**H01S 5/042** (2006.01)     **H01S 5/11** (2021.01)

(52) Cooperative Patent Classification (CPC):
**H01S 5/11; H01S 5/0421;** H01S 5/04254;
H01S 5/185; H01S 5/187; H01S 2301/163;
H01S 2301/166

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.07.2024 JP 2024110403**

(71) Applicants:
• **SUMITOMO ELECTRIC INDUSTRIES, LTD.**
  **Osaka-shi, Osaka 541-0041 (JP)**
• **Kyoto University**
  **Kyoto-shi, Kyoto 606-8501 (JP)**

(72) Inventors:
• **Sawada, Yusuke**
  **Osaka-shi, Osaka, 541-0041 (JP)**

• **Ito, Yuki**
  **Osaka-shi, Osaka, 541-0041 (JP)**
• **Aoki, Takeshi**
  **Osaka-shi, Osaka, 541-0041 (JP)**
• **Noda, Susumu**
  **Kyoto-shi, Kyoto, 606-8501 (JP)**
• **De Zoysa, Menaka**
  **Kyoto-shi, Kyoto, 606-8501 (JP)**
• **Inoue, Takuya**
  **Kyoto-shi, Kyoto, 606-8501 (JP)**
• **Yoshida, Masahiro**
  **Kyoto-shi, Kyoto, 606-8501 (JP)**
• **Ishizaki, Kenji**
  **Kyoto-shi, Kyoto, 606-8501 (JP)**

(74) Representative: **Grünecker Patent- und Rechtsanwälte**
**PartG mbB**
**Leopoldstraße 4**
**80802 München (DE)**

(54) **PHOTONIC-CRYSTAL SURFACE EMITTING LASER AND METHOD OF MANUFACTURING THE SAME**

(57)     A photonic-crystal surface emitting laser (100, 110) includes a first semiconductor layer (12, 16), an active layer (18) stacked on the first semiconductor layer, a photonic crystal layer (14) stacked on or under the active layer, a second semiconductor layer (22) provided opposite to the first semiconductor layer with respect to the active layer, a first electrode (24) electrically connected to the first semiconductor layer, and a second electrode (26) electrically connected to the second semiconductor layer. The photonic crystal layer has a first region (30) and a plurality of second regions (32, 34) each having a refractive index different from a refractive index of the first region. The second semiconductor layer has a plurality of ring portions (42). The plurality of ring portions form a multi-ring structure.

FIG. 3B

EP 4 679 643 A1

## Description

TECHNICAL FIELD

The present disclosure relates to a photonic-crystal surface emitting laser and a method of manufacturing the same.

BACKGROUND

A photonic-crystal surface emitting laser (PCSEL) in which a photonic-crystal and an active layer having an optical gain are stacked is known. A technique for operating the PCSEL in a single mode has been researched (see Patent literature: International Publication Pamphlet No. WO 2016/031966).

SUMMARY

Voltage is applied to an electrode to inject carriers into a semiconductor layer. Carrier density injected near an outer periphery may be higher than carrier density injected near a center. Higher order modes are likely to be excited and an oscillation in a single mode is difficult. Thus, an object is to provide a photonic-crystal surface emitting laser capable of contributing to an oscillation in a single mode and a method of manufacturing the same.

(1) A photonic-crystal surface emitting laser according to the present disclosure includes a first semiconductor layer, an active layer stacked on the first semiconductor layer, a photonic crystal layer stacked under the active layer, a second semiconductor layer provided opposite to the first semiconductor layer with respect to the active layer, a first electrode electrically connected to the first semiconductor layer, and a second electrode electrically connected to the second semiconductor layer. The photonic crystal layer has a first region and a plurality of second regions each having a refractive index different from a refractive index of the first region. The second semiconductor layer has a plurality of ring portions. The plurality of ring portions form a multi-ring structure. The carrier density becomes higher near a center of the multi-ring structure and becomes lower near the outer periphery. Higher order modes are suppressed, and the fundamental mode is likely to be excited. It is possible to contribute to an oscillation in the single mode.

(2) In the above configuration (1), among the plurality of ring portions, a ring portion closer to a center of the multi-ring structure may have a larger width and a ring portion closer to an outer periphery of the multi-ring structure may have a smaller width. The carrier density becomes higher near the center and lower towards the outer periphery. Higher order modes are suppressed, and the fundamental mode becomes likely to be excited. It is possible to contribute to the oscillation in the single mode.

(3) In the above configuration (1) or (2), the plurality of ring portions may each have a width determined based on a Gaussian function. The carrier density becomes higher near the center and lower towards the outer periphery. Higher order modes are suppressed, and the fundamental mode becomes likely to be excited. It is possible to contribute to the oscillation in the single mode.

(4) In any one of the above configurations (1) to (3), the second electrode may cover the plurality of ring portions. Since the second electrode reflects light, the output of light can be increased.

(5) In any one of the above configurations (1) to (4), the second semiconductor layer may have a central portion. The central portion may have a width larger than a width of each of the plurality of ring portions. The plurality of ring portions may each surround the central portion. The second electrode may cover the central portion and the plurality of ring portions. The carrier density becomes higher near the center and lower towards the outer periphery. Higher order modes are suppressed, and the fundamental mode becomes likely to be excited. It is possible to contribute to an oscillation in the single mode.

(6) In the above configuration (5), the central portion may have a circular planar shape. The plurality of ring portions may each have a planar shape that is a circular ring. The central portion and the plurality of ring portions may be concentrically arranged. The carrier density becomes high at the center and low near the outer periphery. Higher order modes are suppressed, and the fundamental mode becomes likely to be excited. Circular light can be emitted.

(7) In any one of the above configurations (1) to (6), the photonic-crystal surface emitting laser may include an insulating film provided between the plurality of ring portions. The ring portions can be separated from each other. A carrier density distribution can be changed.

(8) In any one of the above configurations (1) to (7), the plurality of second regions of the photonic crystal layer may be periodically arranged over a range wider than the multi-ring structure of the second semiconductor layer. According to the carrier density distribution, higher order modes are suppressed, and the fundamental mode is likely to be excited.

(9) In any one of the above configurations (1) to (8), the photonic-crystal surface emitting laser may include a third semiconductor layer provided between the active layer and the second semiconductor layer. The first semiconductor layer may have an n-type conductivity. The second semiconductor layer and the third semiconductor layer may each have a p-type conductivity. Since a p-i-n junction is formed, carriers can be injected into the active layer.

(10) A method of manufacturing a photonic-crystal surface emitting laser according to the present disclosure includes: stacking an active layer on a first semiconductor layer; forming a photonic crystal layer; forming a second semiconductor layer opposite to the first semiconductor layer with respect to the active layer; forming a multi-ring structure in the second semiconductor layer; forming a first electrode electrically connected to the first semiconductor layer; and forming a second electrode electrically connected to the second semiconductor layer. The photonic crystal layer has a first region and a plurality of second regions each having a refractive index different from a refractive index of the first region. The second semiconductor layer has a plurality of ring portions. The plurality of ring portions form the multi-ring structure. The carrier density becomes higher near the center of the multi-ring structure and is lower near the outer periphery. Higher order modes are suppressed, and the fundamental mode is likely to be excited. It is possible to contribute to an oscillation in the single mode.

BRIEF DESCRIPTION OF THE DRAWINGS

FIG. 1 is a cross-sectional view illustrating a photonic-crystal surface emitting laser according to a first embodiment.
FIG. 2A is a plan view illustrating a photonic crystal layer.
FIG. 2B is an enlarged plan view of a region of a photonic crystal layer.
FIG. 2C is an enlarged cross-sectional view of a photonic crystal layer.
FIG. 3A is a lower surface view illustrating a photonic-crystal surface emitting laser.
FIG. 3B is an upper surface view illustrating a photonic-crystal surface emitting laser.
FIG. 4A is a schematic diagram illustrating distribution of light.
FIG. 4B is a schematic diagram illustrating distribution of light.
FIG. 5 is a cross-sectional view illustrating a photonic-crystal surface emitting laser according to a comparative example.
FIG. 6A is a schematic diagram illustrating carrier density.
FIG. 6B is a schematic diagram illustrating a carrier density.
FIG. 7 is a diagram illustrating a carrier density distribution.
FIG. 8 is a diagram illustrating a multi-circular ring structure.
FIG. 9A is a diagram illustrating calculation result of a width of a circular ring portion.
FIG. 9B is a diagram illustrating calculation result of a width of the circular ring portion.
FIG. 10 is a diagram illustrating a carrier density distribution.
FIG. 11A is a cross-sectional view illustrating a method of manufacturing a photonic-crystal surface emitting laser.
FIG. 11B is a cross-sectional view illustrating a method of manufacturing a photonic-crystal surface emitting laser.
FIG. 11C is a cross-sectional view illustrating a method of manufacturing a photonic-crystal surface emitting laser.
FIG. 12A is a cross-sectional view illustrating a method of manufacturing a photonic-crystal surface emitting laser.
FIG. 12B is a cross-sectional view illustrating a method of manufacturing a photonic-crystal surface emitting laser.
FIG. 13A is a cross-sectional view illustrating a method of manufacturing a photonic-crystal surface emitting laser.
FIG. 13B is a cross-sectional view illustrating a method of manufacturing a photonic-crystal surface emitting laser.

DETAILED DESCRIPTION

[Description of Embodiments of Present Disclosure]

First, the contents of embodiments of the present disclosure will be listed and explained.

[Details of Embodiments of Present Disclosure]

Specific examples of a photonic-crystal surface emitting laser and a method of manufacturing the same according to embodiments of the present disclosure will be described below with reference to the drawings. The present disclosure is not limited to these examples, and is defined by the scope of the claims, and is intended to include all modifications within the meaning and scope equivalent to the scope of the claims.

<Embodiment>

(Photonic-crystal Surface Emitting Laser)

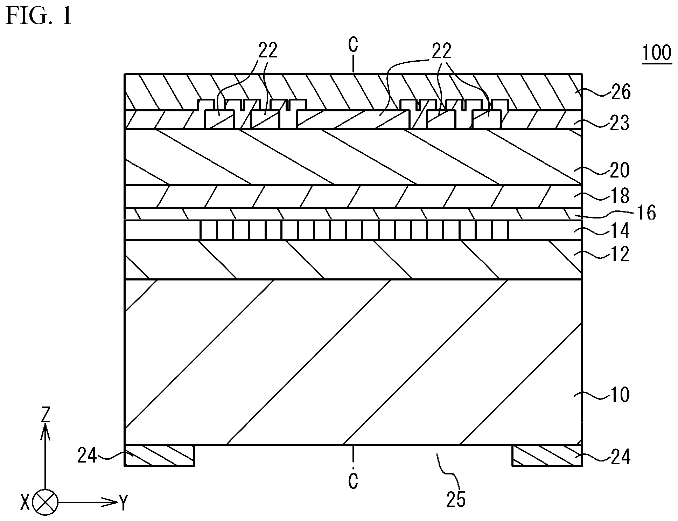

FIG. 1 is a cross-sectional view illustrating a photonic-crystal surface emitting laser 100 according to a first embodiment. As illustrated in FIG. 1, the photonic-crystal surface emitting laser (PCSEL) 100 includes a substrate 10, a cladding layer 12 (first semiconductor layer), a photonic crystal layer 14, a cladding layer 16 (first semiconductor layer), an active layer 18, a cladding layer 20 (third semiconductor layer), a contact layer 22 (second semiconductor layer), an electrode 24 (first electrode), and an electrode 26 (second electrode).
The semiconductor layers are stacked along the Z-axis. The cladding layer 12, the photonic crystal layer 14, the cladding layer 16, the active layer 18, the cladding layer 20, and the contact layer 22 are stacked in this order on the substrate 10. A surface of each layer is parallel to the XY plane. The X-axis, the Y-axis, and the Z-axis are orthogonal to each other. The one dot chain line in FIG. 1 represents a center C of the photonic-crystal surface emitting laser 100 in the XY plane.

The contact layer 22 has a multi-ring structure as described later. An insulating film 23 is provided between rings of the contact layer 22. An upper surface of the contact layer 22 is exposed from the insulating film 23. The electrode 26 is provided on the contact layer 22 and the insulating film 23. The electrode 26 is electrically connected to the contact layer 22. The electrode 24 is in contact with a lower surface of the substrate 10 and is electrically connected to the substrate 10 and the cladding layer 12.

The substrate 10, the cladding layer 12, and the cladding layer 16 are formed of, for example, n-type indium phosphide (n-InP). An n-type dopant is, for example, silicon (Si). A thickness of the cladding layer 12 is, for example, 500 nm. A thickness of the cladding layer 16 is, for example, 100 nm.

The photonic crystal layer 14 is formed of, for example, n-type indium gallium arsenide phosphide (InGaAsP) or aluminum indium gallium arsenide (AlInGaAs). A thickness of the photonic crystal layer 14 is, for example, 300 nm.

The active layer 18 includes a plurality of well layers and barrier layers, and has a Multi Quantum Well (MQW) structure. The well layer and the barrier layer are formed of, for example, undoped indium gallium arsenide phosphide (InGaAsP) or aluminum gallium indium arsenide (AlGaInAs). The active layer 18 has an optical gain.

The cladding layer 20 is formed of, for example, p-type indium phosphide (p-InP). The contact layer 22 includes, for example, p-type indium gallium arsenide phosphide (p-InGaAsP) and p-type indium gallium arsenide (p-InGaAs). The p-InGaAsP layer is stacked on a surface of the cladding layer 20, and the p-InGaAs layer is stacked on the p-InGaAsP layer. A surface of the contact layer 22 is p-InGaAs. A p-type dopant is, for example, zinc (Zn). A thickness of the cladding layer 20 is, for example, 3 $\mu$m. A thickness of the contact layer 22 is, for example, 300 nm. The insulating film 23 is formed of an insulator such as silicon nitride (SiN). The materials described above are examples, and each layer may be formed of other materials, or may be formed of a combination of the materials described above and other materials.

The refractive index of the active layer 18 is, for example, 3.5. The refractive index of each of the cladding layers 12, 16 and 20 is, for example, 3.2. The refractive index of InGaAsP, which is the base material of the photonic crystal layer 14, is larger than that of the cladding layers 12, 16, and 20, and is, for example, 3.4.

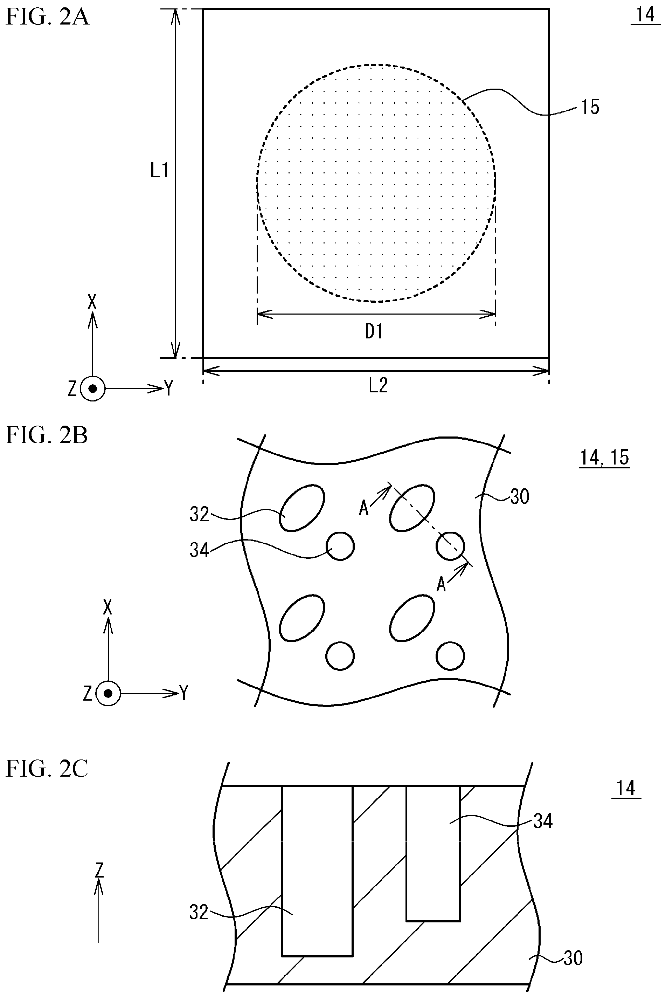

FIG. 2A is a plan view illustrating the photonic crystal layer 14. Lengths L1 and L2 of the sides are, for example, 1000 $\mu$m. A region 15 of the photonic crystal layer 14 is located at a center of the photonic crystal layer 14. The region 15 has a circular planar shape. A diameter D1 of the region 15 is, for example, 300 $\mu$m. An air hole is provided in the region 15.

FIG. 2B is an enlarged plan view of the region 15 of the photonic crystal layer 14. FIG. 2C is an enlarged cross-sectional view of the photonic crystal layer 14, and illustrates a cross-section taken along a line A-A of FIG. 2B. The photonic crystal layer 14 includes a base material 30 (first region), and is provided with an air hole 32, and an air hole 34 (second region). The base material 30 is an InGaAsP layer or the like as described above. The plurality of air holes 32 and a plurality of air holes 34 are provided in the base material 30.

As illustrated in FIG. 2B, the plurality of air holes 32 and air holes 34 are disposed two dimensionally. The plurality of air holes 32 are arranged in a square lattice. The plurality of air holes 34 are arranged in a square lattice. The plurality of air holes 32 and the air holes 34 are periodically arranged in the X-axis direction and the Y-axis direction. The lattice parameter is, for example, 400 nm. That is, in the X-axis direction and the Y-axis direction, the distances between the adjacent air holes 32 and between the adjacent air holes 34 are 400 nm. The air hole 32 has an elliptical planar shape. The major axis and the minor axis of the air hole 32 are inclined from the direction in which the plurality of air holes 32 are disposed. The air hole 34 has a circular planar shape.

As illustrated in FIG. 2C, the air hole 32 and the air hole 34 extend in the Z-axis direction. One end of each of the air hole 32 and the air hole 34 is located on one surface of the photonic crystal layer 14. The other end of each of the air hole 32 and the air hole 34 is located in the middle of the photonic crystal layer 14. The air hole 32 and the air hole 34 may extend through the photonic crystal layer 14 and may extend to the cladding layer 12. The air hole 32 is longer than the air hole 34. The inside of each of the air hole 32 and the air hole 34 is air. The refractive index of each of the air hole 32 and the air hole 34 is different from the refractive index of the base material 30. The refractive index periodically changes in a plane of the photonic crystal layer 14.

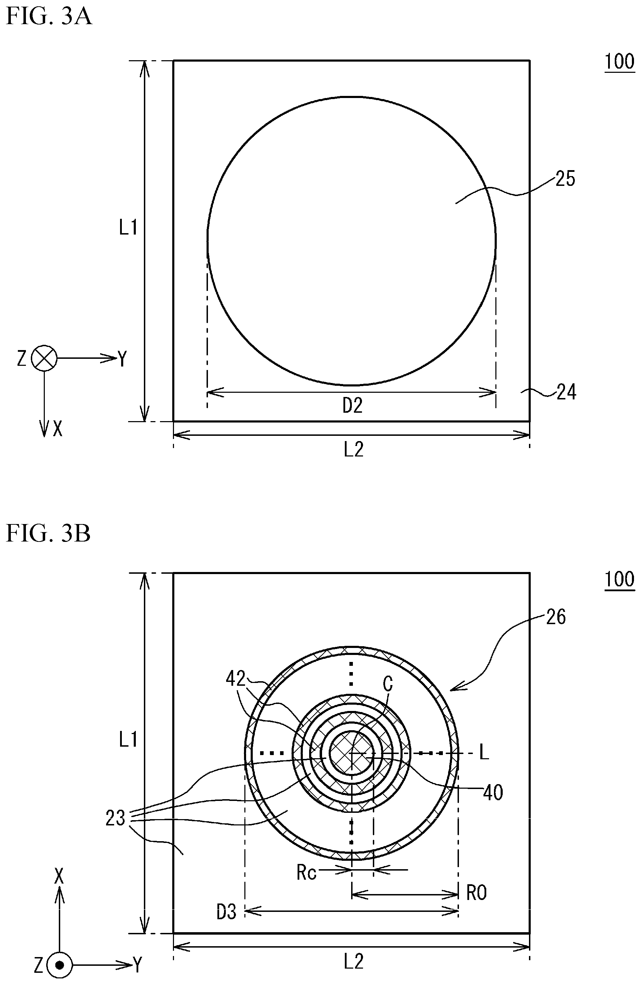

FIG. 3A is a lower surface view illustrating the photonic-crystal surface emitting laser 100. As illustrated in FIG. 3A, an opening 25 is provided in the electrode 24. The opening 25 has a circular planar shape. A diameter D2 of the opening 25 is, for example, 340 $\mu$m. The opening 25 extends through the electrode 24, and the substrate 10 is exposed from the opening 25. The opening 25 functions as an aperture for emitting light.

The electrode 24 is an n-type electrode and is in contact with a surface of the substrate 10. The electrode 24 is formed of a metal, and is formed by stacking, for example, nickel (Ni), germanium (Ge), and gold (Au) in this order from the substrate 10.

FIG. 3B is an upper surface view illustrating the photonic-crystal surface emitting laser 100, and the electrode 26 is seen through. In FIG. 3B, the portions marked with diagonal lines represent the contact layer 22. The portions without diagonal lines are the insulating film 23. A line L will be described later.

The contact layer 22 has a central portion 40 and a plurality of circular ring portions 42 (ring portions). The central portion 40 has a circular planar shape. The circular ring portion 42 has a planar shape that is a circular ring. The central portion 40 and the circular ring portion 42 are concentrically arranged. The central portion 40 is located at a center of the photonic-crystal surface emitting laser 100. One circular ring portion 42 surrounds the central portion 40. The circular ring portion 42 is surrounded by another circular ring portion 42. Similarly, the circular ring portion 42 is arranged outward. That is, the contact layer 22 has a multi-circular ring structure. The central portion 40 and the circular ring portion 42 are spaced apart from each other. The plurality of circular ring portions 42 are spaced apart from each other. The circular ring type insulating film 23 is provided between the central portion 40 and the circular ring portion 42 and between the plurality of circular ring portions 42.

A center of each of the central portion 40 and the circular ring portion 42 of the contact layer 22 coincide with the center C of FIG. 1. A center of the region 15 of the photonic crystal layer 14, a center of the opening 25 of the electrode 24, and the centers of the central portion 40 and the circular ring portion 42 of the contact layer 22 coincide with each other and overlap each other in the Z-axis direction. The central portion 40 and the circular ring portion 42 of the contact layer 22 overlap the region 15 of the photonic crystal layer 14 and the opening 25 of the electrode 24.

A diameter D3 of the outermost one of the plurality of circular ring portions 42 is smaller than the diameter D1 of the region 15 and the diameter D2 of the opening 25, and is, for example, 200 $\mu$m. A distance from the center C of the photonic-crystal surface emitting laser to the circular ring portion 42 located outermost is referred to as a radius R0 of the multi-circular ring structure.

Among the plurality of circular ring portions 42, the circular ring portion having a larger width is located closer to the center of the multi-circular ring structure, and the circular ring portion having a smaller width is located farther from the center and closer to the outer periphery. A diameter of the central portion 40 is larger than the width of any of the circular ring portions 42. A radius Rc of the central portion 40 is, for example, several tens of micrometers.

The sizes of the central portion 40 and the circular ring portion 42 and the number of circular ring portions 42 can be determined according to characteristics required for the photonic-crystal surface emitting laser 100. The number of circular ring portions 42 may be referred to as a division number N of the multi-ring structure.

The electrode 26 is provided on a surface illustrated in FIG. 3B, and covers the central portion 40 and the plurality of circular ring portions 42 of the contact layer 22. The electrode 26 is in contact with an upper surface of the central portion 40 and upper surfaces of the plurality of circular ring portions 42, and is electrically connected to the central portion 40 and the plurality of circular ring portions 42. The electrode 26 is a p-type electrode, and is formed by stacking, for example, titanium (Ti), platinum (Pt), and gold (Au) in this order from the contact layer 22.

The operation of the photonic-crystal surface emitting laser 100 will be described. Voltage is applied to the photonic-crystal surface emitting laser 100 through the electrode 24 and the electrode 26. Light is generated by the injection of carriers into the active layer 18. Light is diffracted and scattered in a plane of the photonic crystal layer 14, and light having a wavelength corresponding to the period of the air holes 32 and the air holes 34 is amplified, thereby causing laser oscillation. A wavelength of the laser light is, for example, in the 1.3 $\mu$m band or the 1.5 $\mu$m band.

The laser light is emitted in the Z-axis direction. The light propagating downward in FIG. 1 is emitted from the opening 25 of the electrode 24. The light propagating upward is reflected from a lower surface of the electrode 26, propagates downward, and is emitted from the opening 25.

It is desired to operate the photonic-crystal surface emitting laser 100 in a single mode (fundamental mode). However, higher order modes may be excited together with the fundamental mode.

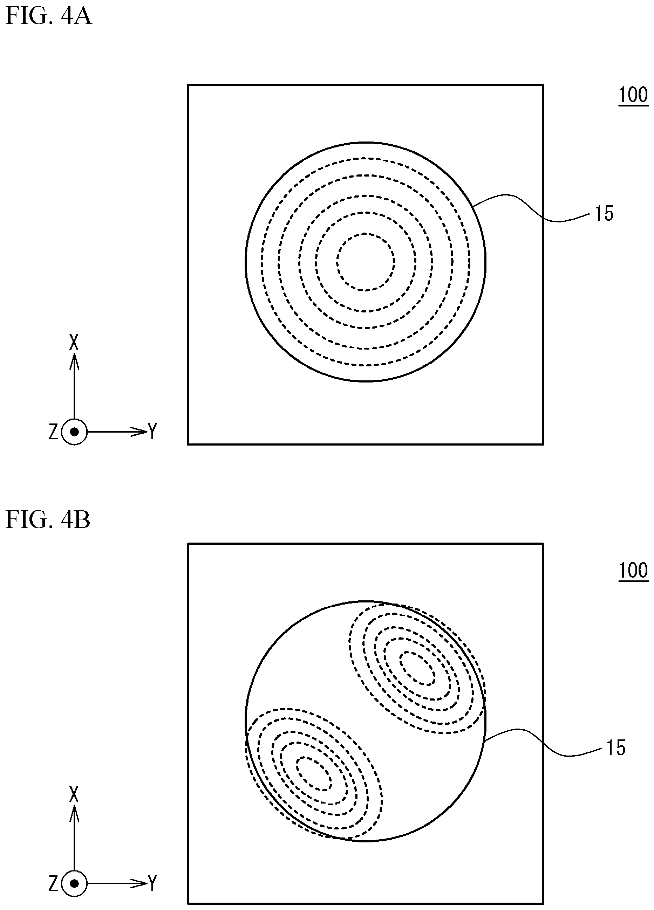

FIG. 4A and FIG. 4B are schematic diagrams illustrating the distribution of light. FIG. 4A illustrates the fundamental mode. FIG. 4B illustrates higher order modes. The light is showed by dotted lines. As illustrated in FIG. 4A, the fundamental mode is strongly distributed at the center and is weakly distributed toward the outside. As illustrated in FIG. 4B, higher order modes are distributed so as to spread outward. In order to perform oscillation in the single mode, it is only necessary for the fundamental mode to be oscillated and for higher order modes to be suppressed.

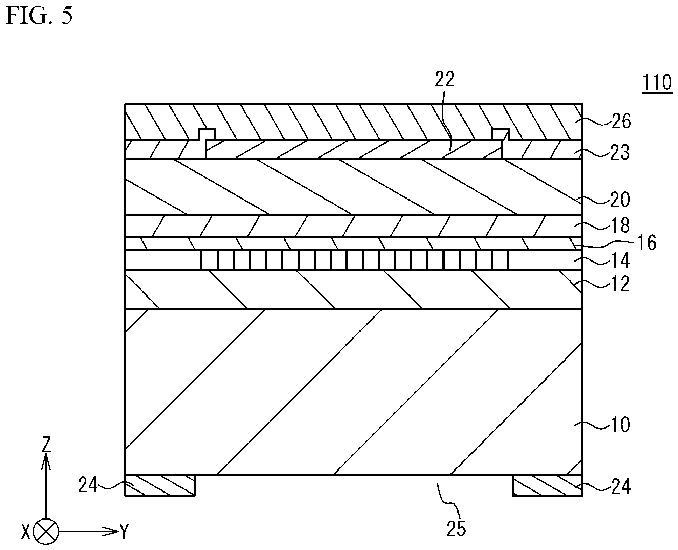

FIG. 5 is a cross-sectional view illustrating a photonic-crystal surface emitting laser 110 according to a comparative example. The contact layer 22 does not have a multi-ring structure, and is a single layer. The contact layer 22 has a circular planar shape. The electrode 26 is provided on the contact layer 22 and the insulating film 23, and is electrically connected to the contact layer 22.

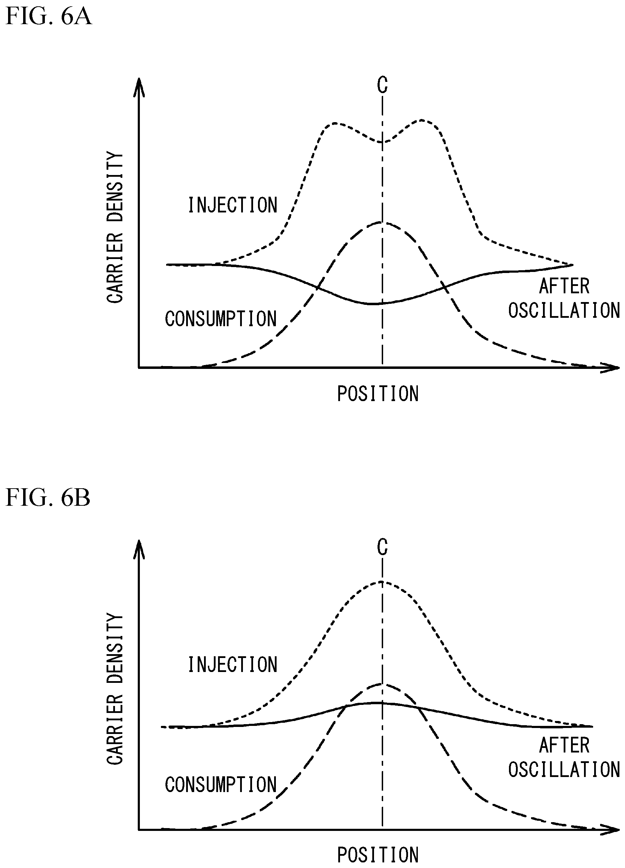

FIG. 6A and FIG. 6B are schematic diagrams illustrating carrier density. The horizontal axis is at a position in the photonic-crystal surface emitting laser, and represents a position along the Y-axis direction. C represents the center of the photonic-crystal surface emitting laser. The vertical axis represents the carrier density. The dotted line represents the carrier density injected into the active layer 18. The dashed line represents the carrier density consumed. The solid line represents the carrier density after oscillation.

FIG. 6A illustrates the carrier density in the comparative example. The injected carrier density near the outer periphery is higher than the injected carrier density at the center C. The position where the carrier density is high corresponding near the outer periphery of the region 15 of the photonic crystal layer 14 and the contact layer 22. The consumed carrier density becomes higher at the center and lower towards the outer periphery. The carrier density after oscillation becomes higher near the outer periphery and lower at the center. Since the carrier density after oscillation is high near the outer periphery, higher order modes are likely to be excited.

FIG. 6B illustrates carrier density in an embodiment. The injected carrier density and the consumed carrier density become higher at the center and lower toward the outer periphery. The carrier density after oscillation becomes nearly flat. Higher order modes are suppressed, and the fundamental mode is likely to be excited.

The photonic-crystal surface emitting laser 100 is designed so as to achieve a carrier density as illustrated in FIG. 6B.

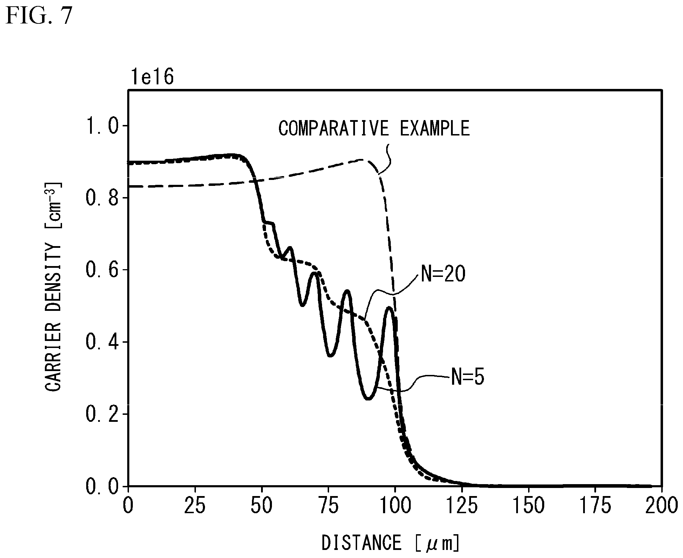

FIG. 7 is a diagram illustrating a carrier density distribution. The horizontal axis represents a distance from the center C of the photonic-crystal surface emitting laser. 0 represents a position of the center C. The larger the value on the horizontal axis, the closer to the outer periphery of the photonic-crystal surface emitting laser. The position of 100 $\mu$m is near an end of the multi-circular ring structure of the contact layer 22. The diameter of the central portion 40 of the contact layer 22 is 50 $\mu$m.

The vertical axis of FIG. 7 represents carrier density (electron density). The dashed line represents comparative examples. The solid line represents an example in which the division number of the multi-circular ring structure is five (N is equal to five) in the embodiment. The dotted line represents an example in which the division number of the multi-circular ring structure is 20 (N is equal to 20) in the embodiment.

As indicated by the dashed line in FIG. 7, in the comparative example, the carrier density near the outer periphery (near 100 $\mu$m) of the contact layer 22 is higher than the carrier density at the center. As indicated by the solid line and the dotted line, according to the embodiment, the carrier density near the outer periphery becomes lower than the carrier density at the center. The range of 0 $\mu$m to 50 $\mu$m on the horizontal axis corresponds to the central portion 40 of the contact layer 22. In the embodiment, the carrier density of the central portion 40 is substantially flat. The carrier density decreases from the central portion 40 toward the outer periphery. Corresponding to the multi-circular ring structure, the carrier density is pulsating. In the example where N is equal to five, indicated by the solid line, the amplitude of the carrier density is large. In the example where N is equal to 20, indicated by the dotted line, the amplitude is small and changes stepwise.

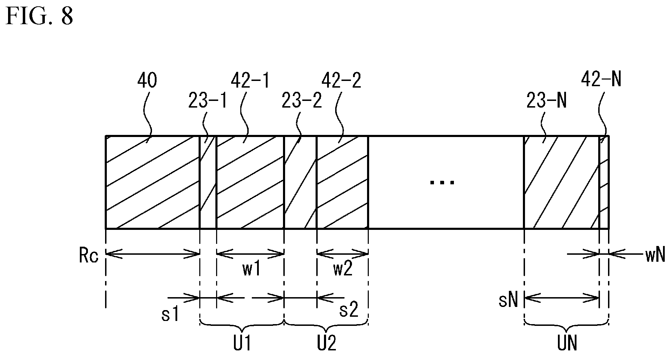

Next, a design example of the multi-circular ring structure will be described. FIG. 8 is a diagram illustrating the multi-circular ring structure, and illustrates a cross-section taken along the line L of FIG. 3B. The division number is N. The contact layer 22 has the central portion 40 and N circular ring portions. The circular ring portions are referred to as a circular ring portion 42-1, a circular ring portion 42-2, ..., a circular ring portion 42-N in order from the central portion 40 toward the outside. The circular ring portion 42-2 surrounds the circular ring portion 42-1. An outer circular ring portion surrounds the inner circular ring portion.

The insulating film 23 is divided into N circular ring portions. The circular ring portions of the insulating film 23 are referred to as a circular ring portion 23-1, a circular ring portion 23-2,..., a circular ring portion 23-N in order from the central portion 40 toward the outside. The circular ring portion 23-1 of the insulating film 23 is provided between the central portion 40 and the circular ring portion 42-1 of the contact layer 22. The circular ring portion 23-2 is provided between the circular ring portion 42-1 and the circular ring portion 42-2. The circular ring portions of the contact layer 22 and the circular ring portions of the insulating film 23 are alternately disposed. The circular ring portion 42-N of the contact layer 22 is located outside a circular ring portion 23-10 of the insulating film 23.

Two adjacent circular ring portions are referred to as a unit. The circular ring portion 42-1 of the contact layer 22 and the circular ring portion 23-1 of the insulating film 23 form a unit U1. The circular ring portion 42-2 and the circular ring portion 23-2 form a unit U2. N units are formed.

As illustrated in FIG. 4B, in order to make the carrier density high at the center and low at the outer periphery, the dimension of the contact layer 22 is set to appropriate values. Widths of the circular ring portions of the contact layer 22 are denoted as w1, w2, ... , wN. Widths of the circular ring portions of the insulating film 23 are denoted as s1, s2,..., sN. The radius Rc of the central portion 40 of the contact layer 22 is larger than any of the widths w1 to wN of the circular ring portion. Among the plurality of the circular ring portions 42-1 to 42-N, a circular ring portion closer to the central portion 40 has a larger width and a circular ring portion farther away from the central portion 40 has a smaller width.

For example, the width can be determined based on the Gaussian function. A width wk of the circular ring portion of the contact layer 22 is calculated by the following equation.

[Equation 1]

$$wk = wm + A\exp\left[-\frac{x^2}{2\sigma^2}\right]$$

The k is a number of the circular ring portion from 1 to N.

The x represents a distance from the center. The σ is a parameter and can be any value. The wm is the lower limit of the width, determined by the accuracy of the manufacturing step, and it is, for example, 1 μm.

The coefficient A in Equation 1 is expressed by the following equation, for example.

[Equation 2]

$$A = \frac{R0 - Rc}{N} - 2$$

R0 is the radius of the multi-circular ring structure. Rc is the radius of the central portion 40 (see FIG. 3B). The "2" in Equation 2 is determined by the lower limit of the width.

The width of the circular ring portion of the insulating film 23 is calculated by the following equation.

[Equation 3]

$$sk = \frac{R0 - Rc}{N} - wk$$

In Equation 2 and Equation 3, (R0 - Rc)/N represents a width of one unit. The width of the unit is a constant value, and the width of the unit is divided into the width wk of the circular ring portion 42 of the contact layer 22 and the width sk of the circular ring portion of the insulating film 23.

In the following example, R0 is set to be equal to 100 μm, Rc is set to be equal to 10 μm, and N is set to be equal to 10. The width of one unit is 9 μm. From Equation 2, A is calculated to be equal to seven.

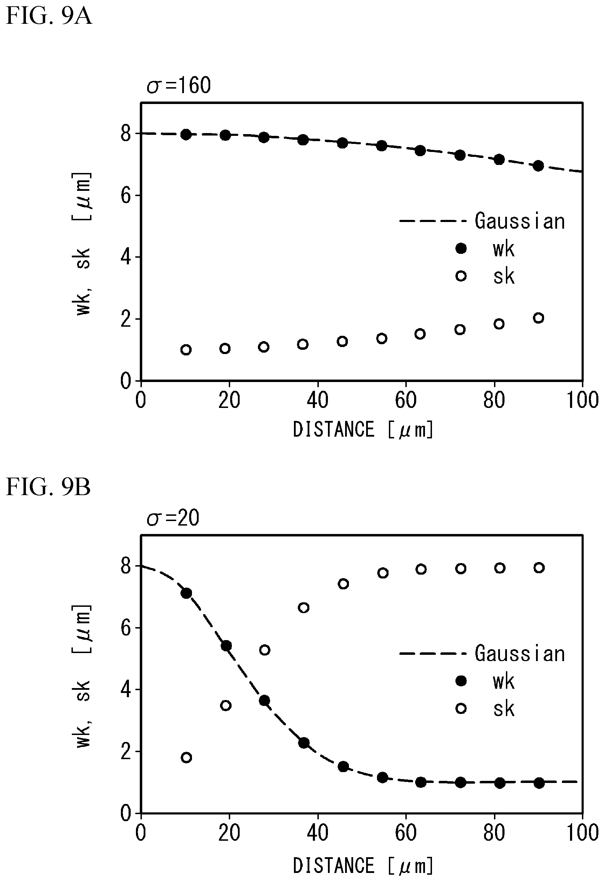

FIG. 9A and FIG. 9B are diagrams illustrating the calculation results of the width of the circular ring portion. The horizontal axis represents a distance from the center of the photonic-crystal surface emitting laser. The vertical axis represents the widths wk and sk. The black circle represents the width wk of the circular ring portion of the contact layer 22. The white circle represents the width sk of the circular ring portion of the insulating film 23. The dashed line represents the width wk calculated by the Gaussian function of Equation 1.

FIG. 9A illustrates an example in which σ is equal to 160 in Equation 1. FIG. 9B illustrates an example in which σ is equal to 20 in Equation 1. As illustrated in FIG. 9A and FIG. 9B, the width wk of the circular ring portion of the contact layer 22 changes according to the Gaussian function, and is larger as it is closer to the center and is smaller as it is closer to the outer periphery. The width sk of the circular ring portion of the insulating film 23 is smaller near the center and is larger near the outer periphery. As in the example of FIG. 9A, when the parameter σ is large, the width wk changes slowly. As in the example of FIG. 9B, when the parameter σ is small, the width wk changes rapidly.

When σ is equal to 20, the width w1 of the circular ring portion 42-1 of the contact layer 22 is 7.177 μm and the width s1 of the circular ring portion 23-1 of the insulating film 23 is 1.823 μm. The width w2 of the circular ring portion 42-2 is 5.481 μm, and the width s2 of the circular ring portion 23-2 is 3.519 μm. The width w3 of a circular ring portion 42-3 is 3.668 μm, and the width s3 of a circular ring portion 23-3 is 5.332 μm. The width w4 of a circular ring portion 42-4 is 2.304 μm, and the width s4 of a circular ring portion 23-4 is 6.696 μm. The width w5 of a circular ring portion 42-5 is 1.523 μm, and the width s5 of a circular ring portion 23-5 is 7.477 μm. The width w6 of a circular ring portion 42-6 is 1.172 μm, and the width s6 of a circular ring portion 23-6 is 7.828 μm. The width w7 of a circular ring portion 42-7 is 1.047 μm, and the width s7 of a circular ring portion 23-7 is 7.953 μm. The width w8 of a circular ring portion 42-8 is 1.010 μm, and the width s8 of a circular ring portion 23-8 is 7.990 μm. The width w9 of a circular ring portion 42-9 is 1.002 μm, and the width s9 of a circular ring portion 23-9 is 7.998 μm. The width w10 of a circular ring portion 42-10 is 1.000 μm, and the width s10 of the circular ring portion 23-10 is 8.000 μm.

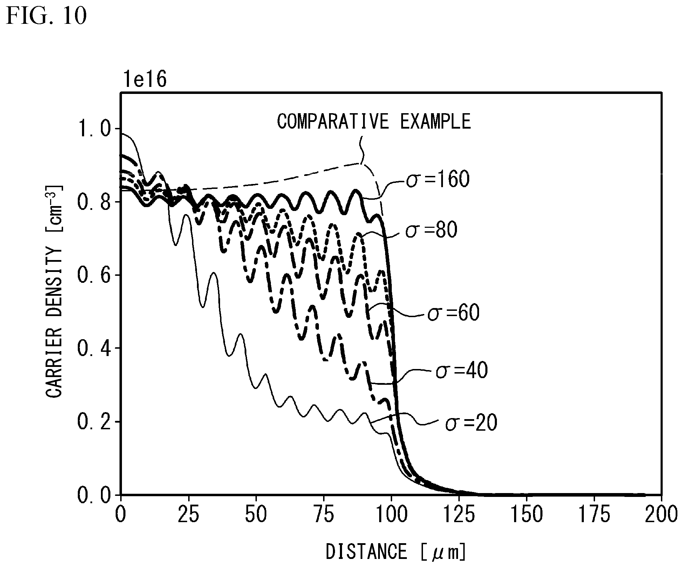

FIG. 10 is a diagram illustrating a carrier density distribution. The horizontal axis represents the distance from the center of the photonic-crystal surface emitting laser. The vertical axis represents the carrier density.

The thin dashed line represents a comparative example. The other lines represent embodiments. The thick solid line represents an example where σ is equal to 160. The dotted line represents an example where σ is equal to 80. The thick dashed line represents an example where σ is equal to 60. The one dot chain line represents an example where σ is equal to 40. The thin solid line represents an example where σ is equal to 20.

According to the embodiment, the carrier density near the outer periphery can be lowered compared to the comparative example. As σ is reduced, the carrier density decreases rapidly from the center toward the outer periphery. That is, the carrier density at the center becomes higher, and the carrier density at the outer periphery is lower.

(Method of Manufacturing)

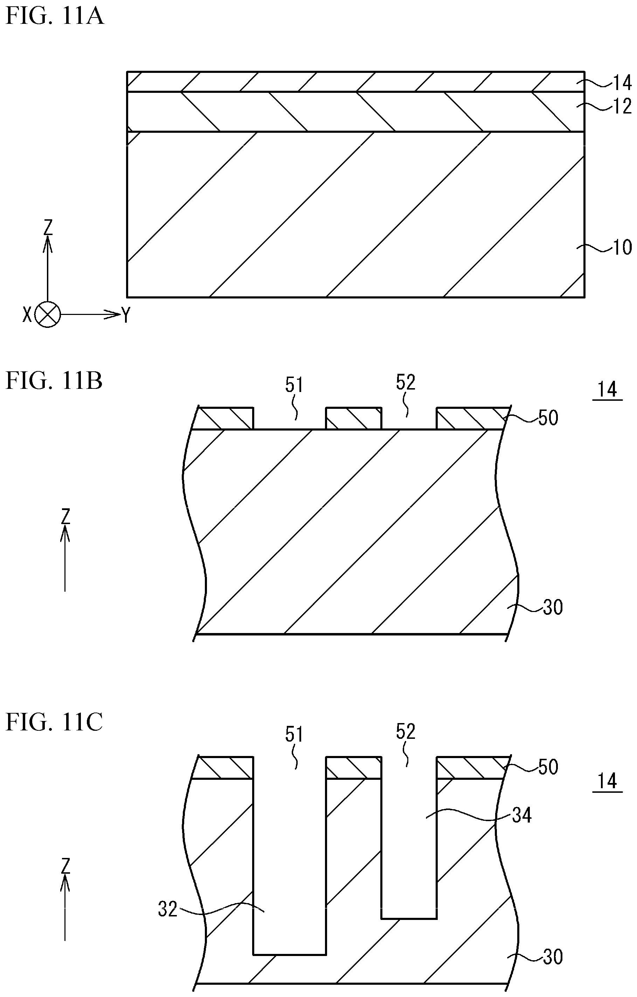

FIG. 11A to FIG. 13B are cross-sectional views illustrating a method of manufacturing the photonic-crystal surface emitting laser 100. As illustrated in FIG. 11A, the cladding layer 12 and the photonic crystal layer 14 are epitaxially grown in this order on the substrate 10 by, for example, Metal Organic Chemical Vapor Deposition (MOCVD) method. In this step, the base material 30 (InGaAsP) of the photonic crystal layer 14 is formed, but an air hole is not formed.

FIG. 11B and FIG. 11C are enlarged views of the photonic crystal layer 14. As illustrated in FIG. 11B, a mask 50 is provided on the upper surface of the photonic crystal layer 14. The mask 50 is formed of an insulator such as SiN. An insulating film is formed on the upper surface of the photonic crystal layer 14. A resist pattern is formed by an electron beam (EB) or the like, and the resist pattern is transferred to the insulating film, thereby forming the mask 50. The mask 50 has an opening 51 and an opening 52. An upper surface of the base material 30 is exposed from the opening 51 and the opening 52. The plurality of openings 51 and the plurality of openings 52 are disposed two dimensionally.

As illustrated in FIG. 11C, the air hole 32 and the air hole 34 are formed in the photonic crystal layer 14 by Reactive Ion Etching (RIE) or the like. The etching proceeds, for example, partway into the photonic crystal layer 14, and does not proceed to a lower surface of the photonic crystal layer 14. The air hole 32 is formed at a position overlapping the opening 51 of the mask 50. The air hole 34 is formed at a position overlapping the opening 52. The planar shapes of the air hole 32 and the air hole 34 are determined by the planar shapes of the opening 51 and the opening 52. By making the opening 51 elliptical and the opening 52 circular, the elliptical air hole 32 and the circular air hole 34 are formed as illustrated in FIG. 2B. After the etching is completed, the mask 50 is removed.

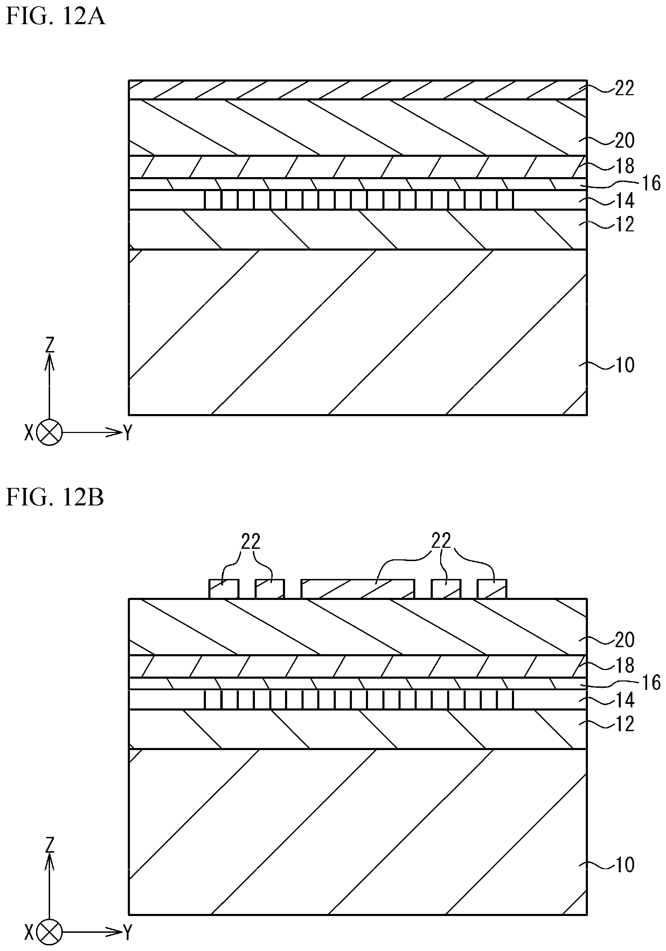

As illustrated in FIG. 12A, the cladding layer 16, the active layer 18, the cladding layer 20, and the contact layer 22 are epitaxially grown on the photonic crystal layer 14. The air hole 32 and the air hole 34 are closed by the cladding layer 16. The inside of the air hole is not filled with the cladding layer 16, and is a cavity. The active layer 18, the cladding layer 20, and the contact layer 22 are formed on the flat cladding layer 16.

As illustrated in FIG. 12B, the contact layer 22 is subjected to dry etching or the like to form the multi-circular ring structure. As illustrated in FIG. 4A, the central portion 40 and the circular ring portion 42 are formed in the contact layer 22. The cladding layer 20 is exposed between the circular ring portions 42. The width of the contact layer 22 can be set to a desired dimension by determining the size of a mask (not illustrated) used for etching based on the Gaussian function as in Equation 1, for example.

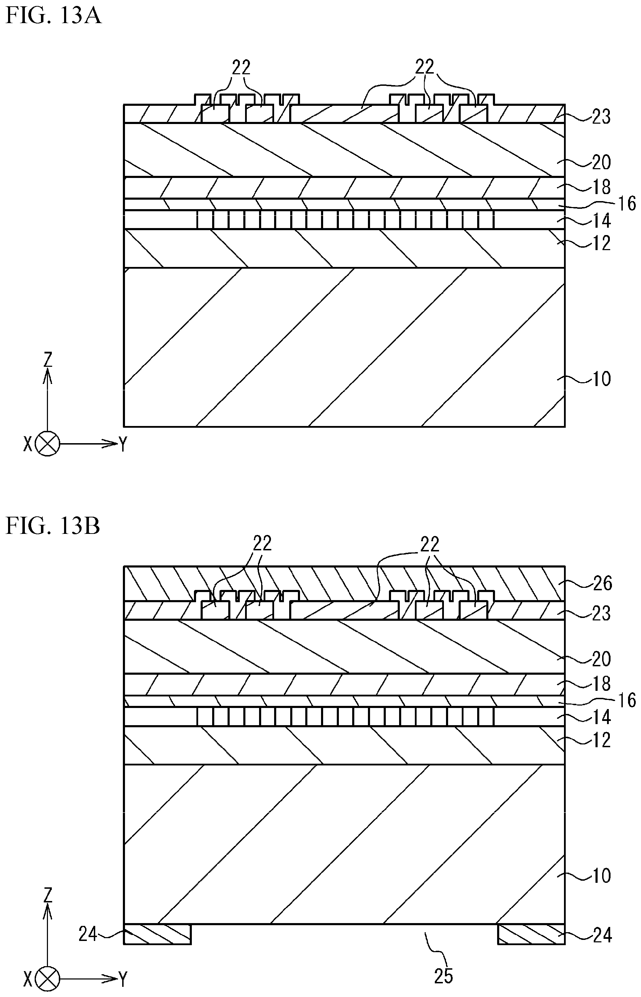

As illustrated in FIG. 13A, the insulating film 23 is formed by, for example, a plasma CVD method. A portion of the insulating film 23 overlapping the contact layer 22 is removed by etching.

As illustrated in FIG. 13B, the electrode 26 is provided on the contact layer 22, for example by vacuum deposition and lift-off. The electrode 26 covers the central portion 40 and the plurality of circular ring portions 42 of the contact layer 22. The electrode 24 is provided on the lower surface of the substrate 10. The electrode 24 has the opening 25. The photonic-crystal surface emitting laser 100 is formed by the above steps.

According to the embodiment, the contact layer 22 has the multi-circular ring structure, and includes the central portion 40 and the plurality of circular ring portions 42 as illustrated in FIG. 3B. The electrode 26 covers the central portion 40 and the plurality of circular ring portions 42. When voltage is applied to the electrode 26, carriers are injected. Since the contact layer 22 has the multi-circular ring structure, the carrier density becomes higher near the center of the multi-circular ring structure and lower towards the outer periphery. Higher order modes are suppressed, and the fundamental mode becomes likely to be excited. It is possible to contribute to an oscillation in the single mode.

The contact layer 22 has, for example, ten circular ring portions from the circular ring portion 42-1 to the circular ring portion 42-10. The circular ring portion 42-1 is located at the innermost side. The circular ring portion 42-10 is located at the outermost side. The circular ring portion closer to the center has a larger width, and the circular ring portion closer to the outer periphery has a smaller width. The carrier density becomes higher near the center and lower towards the outer periphery. Higher order modes are suppressed, and the fundamental mode becomes likely to be excited. It is possible to contribute to an oscillation in the single mode.

As in the example of Equation 1, the width wk of the plurality of circular ring portions can be determined based on the Gaussian function. The width becomes larger the closer it is to the center, and smaller the farther it is from the center. The carrier density becomes higher at the center and lower near the outer periphery. Higher order modes are suppressed, and the fundamental mode becomes likely to be excited.

As illustrated in FIG. 9A and FIG. 9B, the width becomes larger at the center and the width becomes smaller toward the outer periphery. As illustrated in FIG. 10, the difference in carrier density distributions can be increased from the center to the outer periphery. Higher order modes are suppressed, and the fundamental mode becomes likely to be excited. For the design of width, the Gaussian function including a coefficient different from Equation 1 may be used, or a function other than the Gaussian function may be used.

The electrode 26 covers the central portion 40 and the plurality of circular ring portions of the contact layer 22. An area of the electrode 26 is similar to that of the comparative example. Light emitted from the active layer 18 is reflected from the lower surface of the electrode 26. Since the area of the electrode 26 does not need to be small, high output is possible.

As illustrated in FIG. 3B, the contact layer 22 has the central portion 40 and the plurality of circular ring portions 42. The plurality of circular ring portions 42 surround the central portion 40. The electrode 26 covers the central portion 40 and the plurality of circular ring portions 42. Carriers can be injected from the entire contact layer 22. The width (diameter) of the central portion 40 is larger than the width wk of the circular ring portion 42. The carrier density becomes high at the center and low near the outer periphery. Higher order modes are suppressed, and the fundamental mode becomes likely to be excited. Since the area of the electrode 26 does not need to be small, high output is possible.

The division number N may be 2 or more, 5 or more, 10 or more, or 20 or more. The plurality of circular ring portions 42 may include circular ring portions having the same width. For example, the contact layer 22 may have 10 or more circular ring portions 42, and two adjacent circular ring portions 42 may have the same width.

The central portion 40 has a circular planar shape. The circular ring portion 42 has a planar shape that is a circular ring. The central portion 40 and the plurality of circular ring portions 42 are concentrically arranged. The carrier density becomes high at the center and low near the outer periphery. Higher order modes are suppressed, and the fundamental mode becomes likely to be excited. Circular light can be emitted corresponding to the shape of the contact layer 22.

The arrangement of the central portion 40 and the circular ring portion 42 do not have to be concentric. The centers of the plurality of circular ring portions 42 may be shifted from each other. The center of the central portion 40 may be shifted from the center of the circular ring portion 42.

It is only necessary that the contact layer 22 has the multi-ring structure and includes the plurality of ring portions. In the example of FIG. 3B, the multi-ring structure is a multi-circular ring structure, and the ring portion is the circular ring portion 42. The ring portion may have a shape other than a circle, for example, an elliptical, closed curve, or polygonal. The central portion 40 may have a shape other than a circle, such as elliptical and polygonal. The contact layer 22 may have only the circular ring portion 42 without the central portion 40. The circular ring portion 42 having a maximum width is located at the center. The carrier density becomes high at the center and low near the outer periphery.

The insulating film 23 is provided between the plurality of circular ring portions 42, and is provided between the central portion 40 and the circular ring portion 42. The plurality of circular ring portions 42 are separated from each other. The central portion 40 and the circular ring portion 42 are separated from each other. The carrier density distribution can be changed.

The diameter D1 of the region 15 of the photonic crystal layer 14 is larger than the diameter D3 of the multi-circular ring structure. The plurality of air holes 32 and air holes 34 are periodically arranged over a range wider than the multi-circular ring structure. The active layer 18 generates light by the injection of carriers. The light repeats diffraction, scattering, and the like in a plane of the photonic crystal layer 14, and laser oscillation occurs. According to the carrier density distribution, higher order modes are suppressed, and the fundamental mode is likely to be excited.

The center of the region 15 of the photonic crystal layer 14, the center of the opening 25 of the electrode 24, and the center C of the multi-circular ring structure of the contact layer 22 coincide with each other. According to the carrier density distribution, higher order modes are suppressed, and the fundamental mode is likely to be excited. The laser light is emitted from the opening 25. Light of the fundamental mode can be extracted.

The center of the region 15, the center of the opening 25 of the electrode 24, and the center C of the multi-circular ring structure of the contact layer 22 do not have to coincide with each other. The region 15, the opening 25, and the multi-circular ring structure overlap in the Z-axis direction, and thus laser light is generated and emitted.

The substrate 10, the cladding layer 12, the photonic crystal layer 14, and the cladding layer 16 have n-type conductivity. The active layer 18 is a non-doped layer. The cladding layer 20 and the contact layer 22 have p-type conductivity. These layers are stacked to form a p-i-n junction (positive-intrinsic-negative), and carriers can be injected into the active layer 18. The conductivity type may be reversed. An n-type layer is provided on one side of the active layer 18, and a p-type layer is provided on the other side of the active layer 18.

While two types of air holes are used, one type or three or more types may be used. The planar shape of the air hole may be elliptical, circular, or polygonal. In the photonic crystal layer 14, a region having a refractive index different from that of the base material 30 is periodically provided. The region may be an air hole or may be a member different from the base material 30. The photonic crystal layer 14 may be provided between the cladding layer 12 and the active layer 18, or between the active layer 18 and the cladding layer 20.

Although the embodiments of the present disclosure have been described in detail, the present disclosure is not limited to the specific embodiments, and various modifications and changes can be made within the scope of the gist of the present disclosure described in the claims.

**Claims**

1. A photonic-crystal surface emitting laser (100, 110) comprising:

 a first semiconductor layer (12, 16);
 an active layer (18) stacked on the first semiconductor layer;
 a photonic crystal layer (14) stacked on or under the active layer;
 a second semiconductor layer (22) provided opposite to the first semiconductor layer with respect to the active layer;
 a first electrode (24) electrically connected to the first semiconductor layer; and
 a second electrode (26) electrically connected to the second semiconductor layer,
 wherein the photonic crystal layer has a first region (30) and a plurality of second regions (32, 34) each having a refractive index different from a refractive index of the first region,

wherein the second semiconductor layer has a plurality of ring portions (42), and
wherein the plurality of ring portions form a multi-ring structure.

2. The photonic-crystal surface emitting laser according to claim 1, wherein, among the plurality of ring portions, a ring portion closer to a center of the multi-ring structure has a larger width and a ring portion closer to an outer periphery of the multi-ring structure has a smaller width.

3. The photonic-crystal surface emitting laser according to claim 1 or 2, wherein the plurality of ring portions each have a width determined based on a Gaussian function.

4. The photonic-crystal surface emitting laser according to any one of claims 1 to 3, wherein the second electrode covers the plurality of ring portions.

5. The photonic-crystal surface emitting laser according to any one of claims 1 to 4,

wherein the second semiconductor layer has a central portion (40),
wherein the central portion has a width larger than a width of each of the plurality of ring portions,
wherein the plurality of ring portions each surround the central portion, and
wherein the second electrode covers the central portion and the plurality of ring portions.

6. The photonic-crystal surface emitting laser according to claim 5,

wherein the central portion has a circular planar shape,
wherein the plurality of ring portions each have a planar shape that is a circular ring, and
wherein the central portion and the plurality of ring portions are concentrically arranged.

7. The photonic-crystal surface emitting laser according to any one of claims 1 to 6, comprising:
an insulating film (23) provided between the plurality of ring portions.

8. The photonic-crystal surface emitting laser according to any one of claims 1 to 7, wherein the plurality of second regions of the photonic crystal layer are periodically arranged over a range wider than the multi-ring structure of the second semiconductor layer.

9. The photonic-crystal surface emitting laser according to any one of claims 1 to 8, comprising:

a third semiconductor layer provided between the active layer and the second semiconductor layer,
wherein the first semiconductor layer has an n-type conductivity, and
wherein the second semiconductor layer and the third semiconductor layer each have a p-type conductivity.

10. A method of manufacturing a photonic-crystal surface emitting laser, the method comprising:

stacking an active layer (12, 16) on a first semiconductor layer (18);
forming a photonic crystal layer (14);
forming a second semiconductor layer (22) opposite to the first semiconductor layer with respect to the active layer;
forming a multi-ring structure in the second semiconductor layer;
forming a first electrode (24) electrically connected to the first semiconductor layer; and
forming a second electrode (26) electrically connected to the second semiconductor layer,
wherein the photonic crystal layer has a first region (30) and a plurality of second regions (32, 34) each having a refractive index different from a refractive index of the first region,
wherein the second semiconductor layer has a plurality of ring portions (42), and
wherein the plurality of ring portions form the multi-ring structure.

FIG. 1

FIG. 2A

FIG. 2B

FIG. 2C

FIG. 3A

FIG. 3B

FIG. 4A

FIG. 4B

FIG. 5

FIG. 6A

FIG. 6B

FIG. 7

FIG. 8

FIG. 9A

FIG. 9B

FIG. 10

FIG. 11A

FIG. 11B

FIG. 11C

FIG. 12A

FIG. 12B

FIG. 13A

FIG. 13B

Europäisches
Patentamt

European
Patent Office

Office européen
des brevets

# EUROPEAN SEARCH REPORT

**Application Number**

EP 25 18 6212

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/028327 A1 (NODA SUSUMU [JP] ET AL) 23 January 2020 (2020-01-23) * paragraphs [0081] - [0089]; figures 1A,1B,2A,2B,3 * * paragraphs [0108] - [0117]; figures 17A,17B,18 * ----- | 1-10 | INV. H01S5/042 H01S5/11 |
| X | JP 2012 109410 A (CANON KK) 7 June 2012 (2012-06-07) * paragraphs [0027], [0028]; figure 7 * ----- | 1,4-6, 8-10 | |
| X | WO 2024/024190 A1 (SUMITOMO ELECTRIC INDUSTRIES [JP]; UNIV KYOTO [JP]) 1 February 2024 (2024-02-01) * paragraphs [0012] - [0023]; figures 1,2A * -& EP 4 564 619 A1 (SUMITOMO ELECTRIC INDUSTRIES [JP]; UNIV KYOTO [JP]) 4 June 2025 (2025-06-04) * paragraphs [0011] - [0022]; figures 1,2A * ----- | 1,4-6, 8-10 | |

**TECHNICAL FIELDS SEARCHED (IPC)**

H01S

The present search report has been drawn up for all claims

| Place of search | Date of completion of the search | Examiner |
|---|---|---|
| Munich | 25 November 2025 | Riechel, Stefan |

EPO FORM 1503 03.82 (P4C01)

## ANNEX TO THE EUROPEAN SEARCH REPORT
## ON EUROPEAN PATENT APPLICATION NO.

EP 25 18 6212

This annex lists the patent family members relating to the patent documents cited in  the above-mentioned European search report.
The members are as contained in the European Patent Office EDP file on
The European Patent Office is in no way liable for these particulars which are merely given for the purpose of information.

25-11-2025

| Patent document cited in search report | | Publication date | Patent family member(s) | | Publication date |
|---|---|---|---|---|---|
| US 2020028327 | A1 | 23-01-2020 | NONE | | |
| JP 2012109410 | A | 07-06-2012 | JP | 5704901 B2 | 22-04-2015 |
| | | | JP | 2012109410 A | 07-06-2012 |
| WO 2024024190 | A1 | 01-02-2024 | CN | 119522517 A | 25-02-2025 |
| | | | EP | 4564619 A1 | 04-06-2025 |
| | | | JP | WO2024024190 A1 | 01-02-2024 |
| | | | WO | 2024024190 A1 | 01-02-2024 |
| EP 4564619 | A1 | 04-06-2025 | CN | 119522517 A | 25-02-2025 |
| | | | EP | 4564619 A1 | 04-06-2025 |
| | | | JP | WO2024024190 A1 | 01-02-2024 |
| | | | WO | 2024024190 A1 | 01-02-2024 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016031966 A